# EUROPEAN PATENT APPLICATION

(11) **EP 0 717 416 A2**
(43) Date of publication of application: **19.06.1996**
(21) Application number: 95309029.7
(22) Date of filing: 12.12.1995
(51) Int. Cl.: G11C 27/02

(54) **Input circuit for both analog and digital signals**

(30) Priority: 16.12.1994 FI 945943
(71) Applicant: ABB Industry Oy,, FIN-00380 Helsinki (FI)
(72) Inventor: Miettinen, Erkki, FIN-00280 Helsinki (FI)
(74) Representative: Newby, Martin John

(57) **Abstract**

The present invention relates to an input circuit wherein an input signal is converted into a digital binary format by using an A/D converter, irrespective of whether said input signal is originally analog or digital in nature. The input circuit comprises two input poles (A, B), a sampling capacitor (Cs) connected between the input poles (A, B), a first and a second electronic, two-contact switch (Sa, Sb) connected on both sides of the sampling capacitor (Cs) to connect and, correspondingly, disconnect the sampling capacitor (Cs) to and from the input poles (A, B) and the A/D converter (AD), respectively, and protecting diodes (Da1, Da2, Db1, Db2) connected between both input poles (A, B) and the positive and the negative supply voltage (Vcc, Vdd). In order to protect the diodes from overcurrent, the input circuit also comprises first resistors (Ra, Rb) connected in series with the input poles (A, B) and second resistors (Rc, Rd) connected between the first resistors and ground potential.

## Description

The object of the present invention is to provide a universal solution for connecting different input signals to control systems and the like in a floating manner, without any specific galvanic isolation means providing protection against overvoltages and disturbance currents. The present invention thus relates to an input circuit for both analog and digital signals, said input circuit comprising two input poles and a differentially operating sample and hold circuit connected to the input poles, said sample and hold circuit comprising a sampling capacitor connected between the input poles and a first and a second electronic, two-contact switch connected on both sides of the sampling capacitor.

In different adjustment, data collection and control systems, both analog and digital data on the target system is needed. Such data is often forwarded from great distances by using electric cable connections, which may travel along the same routes for instance with high-current motor cables. Such motor cables induce common mode voltages in said signal cables, due to which voltages it is necessary to use for instance isolation amplifiers or opto-isolators to break a galvanic disturbance circuit. Modern components (for instance LSI and ASIC circuits) do not tolerate directly in their input poles almost any type of common or series mode overvoltages.

As regards isolating components, isolation amplifiers as linear components are typically expensive and require in many cases separate subsidiary feed also to the signal to be isolated. As for the opto-isolators used for isolating digital signals, even if less expensive, they require either a current supply ability of several milliamperes of a signal to their LED or, like an isolation amplifier, separate subsidiary feed and additional components to the signal. Both isolation methods also require in the inputs thereof, for their own protection, a number of electronics components against overvoltage peaks possibly occurring in the signal.

It is previously known that an amplifier provided with differential inputs attenuates a common mode signal. The magnitude of the attenuation depends, when common mode direct current is concerned, mainly on the accuracy of the mutual matching of the resistors establishing the connection, but as the frequency increases, asymmetrical stray capacitances and the unideality of the operational amplifier begin to have a degrading effect on the attenuation. Therefore, a pure differential amplifier is not a particularly suitable universal solution in an input circuit.

Another known method for reducing the harmful effects of common mode voltage is the use of a so-called flying capacitor for isolating an input circuit totally from the common mode voltage. In this method, a sample of a signal to be measured is collected to a sampling capacitor by means of two alternately operating two-contact relays and then forwarded to be processed further. This method is not sensitive to the attenuation-reducing effect of the frequency of the common mode voltage if the switches used are of a right type.

The object of the invention is to obviate the problems mentioned above and to provide an input circuit suitable for both an analog and a digital input signal. This object is achieved by means of the input circuit of the invention, characterized in that it further comprises an A/D converter connected to the output of the sample and hold circuit.

Preferably, the input circuit further comprises a voltage divider and a diode clipper protecting both input poles against both common and series mode overvoltages. The diode clipper thus preferably comprises protecting diodes connected between both input poles and the positive and the negative supply voltage, and the voltage divider comprises first resistors connected in series with the input poles and second resistors connected between the first resistors and ground potential.

The input circuit of the invention can be particularly preferably used as an input circuit in integrated circuits. Usually, the number of inputs is limited in this type of circuits, and the inputs have to be implemented in advance to be suitable for either analog or digital signals. However, if a circuit should require for instance more analog inputs than originally designed, it is necessary to use a separate adapter, i.e. one which is external to the circuit, which causes significant costs in addition to causing a need for extra space. With the use of the input circuit of the invention, all inputs can be implemented as similar, and a notification of what type of signal is connected to the input can be provided by means of software so that the input signal can be interpreted correctly. Programming of this type can be performed very easily and at infinitesimal costs.

According to the invention, the A/D converter is most preferably implemented by means of modern circuit technology (LSI, ASIC), the operation of the A/D converter being based on dividing and/or multiplying the charge of the sampling capacitor. Typically, in this type of converter, a sample is taken of the signal to be measured to a sampling capacitor operating in the manner of the flying capacitor mentioned above. This charge is then processed by different successive operations until a desired conversion accuracy is reached. It should be especially pointed out that the A/D converter can be made to be entirely differential in this manner, whereby the time drifts or the drifts due to changes in temperature of the different components of the converter compensate for one another.

In the following, the input circuit of the invention will be described in more detail with reference to the accompanying drawing, in which
Figure 1 shows a schematic circuit diagram of the input circuit of the invention, and
Figure 2 shows the input circuit of Figure 1 as provided with a voltage divider and a diode clipper offering protection against overvoltages.

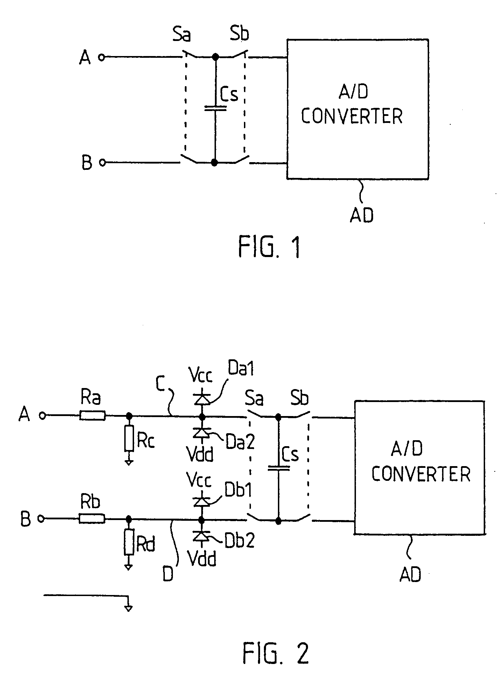

In the circuit diagram of Figure 1, the switch Sa is a fast electronic two-contact switch, which, as it is closed, performs a sampling of an input signal, which is connected to input poles A and B. The switch Sb is open during this time. During the sampling, the capacitor Cs thus "sees" only the difference in voltage between the input poles A and B but not their common mode voltage. Said difference in voltage is, however, precisely the signal to be measured. The switch Sb is a corresponding switch which, as it is closed, transfers the charge of the sampling capacitor Cs to the actual A/D converter AD. The switch Sa is open at this time. It is apparent from the circuit diagram that the A/D converter is entirely disconnected from the measured signal affecting between the input poles A and B during the conversion, the common mode voltage being thus incapable of affecting the conversion in any manner. The duration of an A/D conversion is typically less than one microsecond with a resolution of 8 bits and less than five microseconds with a resolution of 12 bits, i.e. it is possible to perform over a million or, correspondingly, over 200000 conversions in a second, depending on the number of bits of the converter.

To protect the input circuit of the A/D converter described above from induced overvoltage peaks and, on the other hand, from excessive common mode voltage, both input poles A and B can be provided, according to Figure 2, with sample and hold circuit-internal, fast protecting diodes Da1, Da2 and Db1, Db2, respectively, which are connected to the poles Vcc and Vdd of the power supply of the circuit. These protecting diodes can thus be easily integrated into the same integrated circuit with the A/D converter AD and the components Sa, Cs and Sb of the sample and hold circuit. Neither of the input poles is capable, due to the protecting diodes, of exceeding the positive supply voltage Vcc or falling below the negative supply voltage Vdd more than an amount equalling the threshold voltage of the diode. Such exceeding is not harmful to the operation of the circuit.

In order that the diodes not be destroyed by the current generated by a possible overvoltage of the input signal, the connection also comprises resistors Ra and Rb connected in series with the input poles A and B. The input circuit also comprises resistors Rc and Rd, which are connected between the connection points C and D between the protecting diodes and the resistors Ra and Rb of the input poles and ground potential and by means of which is produced voltage division to divide the input signal to a level suitable for the A/D converter AD.

By means of the described input circuit, a common mode level of several tens of volts and a glitch level of hundreds of volts can easily be reached while entirely avoiding the use of the isolation amplifier or the opto-isolator presented above. In addition, the protection requires only two or four external components (resistors Ra - Rd), which can easily be connected for instance to a single hybrid circuit. Separate subsidiary voltage in signal potential is not required, either. The external components together with the sampling capacitor Cs constitute an RC circuit in a sampling situation, the time constant of said circuit being typically no more than a few microseconds. This RC circuit acts as an additional filter against glitches and attenuates them, but it is not too slow for most input signal types, however.

The input circuit of the invention can be used as a universal input by also using the A/D converter AD for measuring digital signals in addition to analog signals. The connection according to Figure 2 is capable of performing an A/D conversion for a differential signal input the voltages of which against ground potential, said voltages being present at the connection points C and D between the resistor Rc and the diodes Da1, Da2 and the resistor Rd and the diodes Db1, Db2, respectively, do not exceed or fall below the supply voltages Vcc and Vdd, respectively. As regards the conversion, there is no difference whether the input signal is analog or digital, as long as it satisfies the potential requirement mentioned above. The input of the invention can thus be used for measuring either a unipolar or bipolar analog voltage or for determining the state of a digital signal of almost an arbitrary level.

In many cases, one pole of the input signal is connected to ground potential, whereby the signal has no common mode part or it has summed up as part of the signal. In such cases, one pole of the input circuit is connected directly to ground potential, and the signal is applied to the other pole. Which one of the input poles the signal is applied to depends on whether the signal is to be measured as inverted or as non-inverted.

The following is an exemplifying description of a case where Vcc is +5 V and Vdd is 0V, and an input defined as digital is to process universally different logic signals within a range of 0 - 48 V. A typical common and series mode operational area is within a range of 0 - 4.5 volts at the points C and D with this supply voltage. An input signal must thus be attenuated by means of the resistors Ra - Rd. If 11.38:1 is selected as the attenuation ratio, the linear measuring range is 0 - 51.2 V, and the resolution of an 8-bit A/D converter (1 LSB), as referred to the signal input, is 200mV, which is a fully sufficient value for determining the 0-state or 1-state for instance in 5-volt TTL logic. If better resolution is desired, a 12-bit A/D converter, for instance, is used, whereby the resolution is 12.5 mV. Decision levels and, if required, hystereses can be set by means of software to a level according to the input signal, and the occurring change in state is detected after a period no longer than the conversion time, i.e. typically in less than one microsecond in this case. This time is short enough for the majority of digital input signals.

The input circuit of the invention has been described above by means of only one illustrating circuit diagram, it being thus apparent that it can be modified to some extent within the scope of the appended claims without altering the electric operation of the circuit.

## Claims

1. An input circuit for both analog and digital signals, said input circuit comprising two input poles (A, B) and a differentially operating sample and hold circuit (Sa, Cs, Sb) connected to the input poles (A, B), said sample and hold circuit comprising a sampling capacitor (Cs) connected between the input poles (A, B) and a first and a second electronic, two-contact switch (Sa, Sb) connected on both sides of the sampling capacitor (Cs), **characterized** in that it further comprises an A/D converter (AD) connected to the output of the sample and hold circuit.

2. An input circuit according to claim 1, **characterized** in that it further comprises a voltage divider (Ra, Rb, Rc, Rd) and a diode clipper (Da1, Da2, Db1, Db2) protecting both input poles (A, B) against both common and series mode overvoltages.

3. An input circuit according to claim 2, **characterized** in that the diode clipper comprises protecting diodes (Da1, Da2, Db1, Db2) connected between both input poles (A, B) and a positive and a negative supply voltage (Vcc, Vdd).

4. An input circuit according to claim 2, **characterized** in that the voltage divider comprises first resistors (Ra, Rb) connected in series with the input poles (A, B) and second resistors (Rc, Rd) connected between the first resistors and ground potential.
